Europäisches Patentamt

European Patent Office

Office européen des brevets

(11) Publication number: 0 509 105 A1

## EUROPEAN PATENT APPLICATION
## published in accordance with Art. 158(3) EPC

(21) Application number: 91918996.9

(22) Date of filing: 01.11.91

(86) International application number: PCT/JP91/01499

(87) International publication number: WO 92/07647 (14.05.92 92/11)

(51) Int. Cl.5: B01D 61/36, B01D 12/00, H01L 21/304

(30) Priority: 02.11.90 JP 297922/90
02.11.90 JP 297923/90

(43) Date of publication of application:
21.10.92 Bulletin 92/43

(84) Designated Contracting States:
DE FR GB

(71) Applicant: DAICEL CHEMICAL INDUSTRIES, LTD.
No. 1-Banchi, Teppo-cho
Sakai-shi Osaka-fu 590(JP)
Applicant: HITACHI, LTD.
6, Kanda Surugadai 4-chome
Chiyoda-ku, Tokyo 101(JP)
Applicant: HOECHST JAPAN LIMITED
10-16, Akasaka 8-chome Minato-ku
Tokyo107(JP)

(72) Inventor: HONDA, Zenjiro 406, 10-13,
Senbanishi 3-chome
Minoo-shi
Osaka 562(JP)
Inventor: MIHARA, Kazuo 966-35, Ikaruga
Taishicho Ibo-gun
Hyogo 671-15(JP)
Inventor: SHINMURA, Yoshiro, Hitachi
Seiwaryo
20-12, Sakai 1-chome
Musashino-shi Tokyo 180(JP)
Inventor: YAMAMOTO, Masashi, Hitachi
Seishinryo
19-1, Josuihoncho 5-chome
Kodaira-shi Tokyo 187(JP)
Inventor: SAKURAI, Toshihiko,
3058-3, Wakashibasho
Ryugasaki-shi, Ibaraki(JP)
Inventor: SHIRAI, Hideki, 29-16, Tsurutacho
Utsunomiya-shi
Tochigi 320(JP)

(74) Representative: Patentanwälte Dipl.-Ing. A.
Grünecker, Dr.-Ing. H. Kinkeldey, Dr.-Ing. W.
Stockmair,
Dr. rer. nat. K. Schumann, Dipl.-Ing. P.H.
Jakob, Dr. rer. nat. G. Bezold
Maximilianstrasse 58
W-8000 München 22(DE)

(54) DEVICE FOR REGENERATING ORGANIC SOLVENT.

(57) An organic solvent evaporating tank having pervaporation membrane modules internally fixed thereto for removing water, and a method of regenerating organic solvent using this tank. It is favorably fit to a system for cleaning with vapor of organic solvent and drying semiconductor material after washing it with water. Application of the invention to the above system will contribute to size reduction of said system, promotion of safety, and improvement in quality of semiconductor material.

# Figure 2

[Field of Industrial Application]

The present invention pertains to an apparatus (organic solvent evaporation bath) being used for cleaning and drying water-washed semiconductor materials, such as wafers, with an organic solvent in the semiconductor manufacturing process. The apparatus has a pervaporation (hereafter referred to as PV) membrane module for removing contaminated water from the organic solvent.

Moreover, the present invention pertains to a method for reclaiming organic solvent which is used for drying semiconductor materials after washed with water.

[Brief Description of the Drawings]

Fig. 1 is a diagram showing a conventional system having an organic-solvent evaporation bath and an apparatus for reclaiming the solvent which is located outside the bath;

Fig. 2 is a diagram showing a system including an organic-solvent evaporation bath according to the present invention in which a PV membrane module is placed to a position where all of the PV membrane module is immersed in a liquid phase of an organic solvent;

Fig. 3 is a diagram showing a system including an organic-solvent evaporation bath according to the present invention in which a PV membrane module is placed to a potion where only the active part of the PV membrane module is immersed in a liquid phase of an organic solvent; and

Fig. 4 is a diagram showing a system including an organic-solvent evaporation bath according to the present invention in which a PV membrane module is placed to a portion where all of the module is located in a vapor phase of an organic solvent.

1 solvent feed pipe
2 solvent liquid phase
3 evaporation bath
4 heater
5 cooler
6 object to be cleaned
7 liquid-feed-pump suction pipe
8 liquid feed pump
9 PV membrane module
10 solvent return pipe
11 vacuum-pump suction pipe
12 condenser
13 cooling-water pipe
14 drain pipe
15 vacuum pump
16 exhaust pump
20 solvent vapor phase

[Background of the Invention]

Isopropanol (hereafter referred to as IPA) is used in a vapor phase to clean and dry wafers in the middle of the semiconductor manufacturing process, for example, in a step after they have been processed and washed with water. The IPA which is used in the step is put in an organic-solvent evaporation bath (hereafter referred to as evaporation bath at times), whose initial purity is 100%. Then the purity of the IPA in the bath decreases as the IPA is repeatedly used, because it absorbs water on the object to be cleaned and dried such as wafers. In general, when the purity of the IPA decreases to 93% or less, spots called water marks due to impurities appear on the wafer surface and thus, the probability of having a semiconductor defect increases, accordingly.

Therefore, the IPA for cleaning and drying is normally replaced with 100% IPA when its purity decreases to 93%. However, a technique has recently been developed to maintain the necessary purity of IPA by installing a solvent reclaiming apparatus for removing the water from the IPA containing water through the PV membrane outside the evaporation bath.

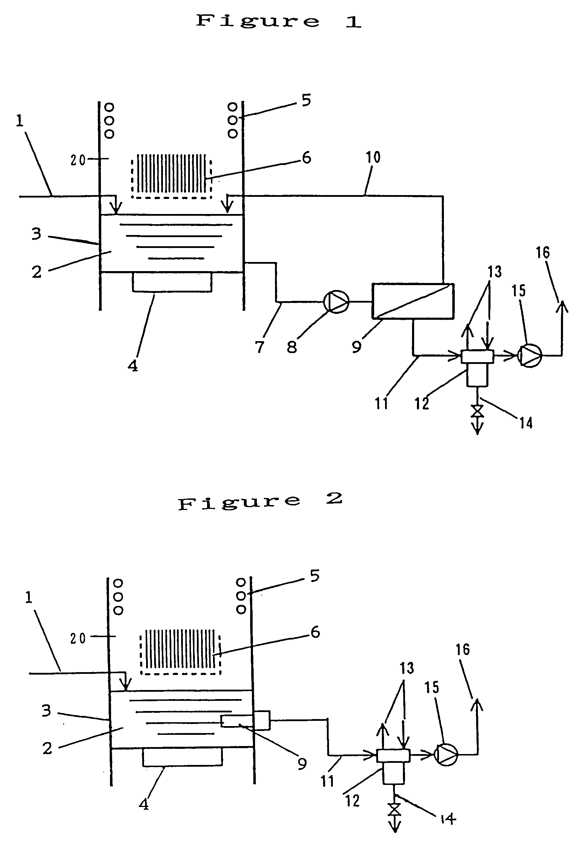

Fig. 1 shows a constitution of the system utilizing an organic-solvent evaporation bath and a solvent reclaiming apparatus outside the bath.

For the constitution as shown in Fig. 1, a liquid-feed pump 8 must be provided to feed a solvent to a PV membrane module. However, the pump cannot use any metal for the portion contacting the solvent in order to prevent the solvent from contamination with a very small amount of metal or metal ions.

Moreover, safety countermeasures should be taken for the pump because the solvent can be easily ignited due to static electricity. That is, the pump actually has various problems on selection of its material or on safety.

Furthermore, it may be difficult to add a solvent reclaiming apparatus including a PV membrane module to the existing evaporation bath because of too small location space. Therefore, a smaller system, including the solvent reclaiming apparatus and the organic-solvent evaporation bath, is required.

US Patent No. 4,788,043 discloses a process for cleaning semiconductor materials with organic solvent. Even for this system, however, the solvent reclaiming apparatus is set outside the solvent evaporation bath. Therefore, the location of the system requires a large space similar to the constitution shown in Fig. 1.

[Disclosure of the Invention]

The present invention was developed in order to solve the above problems and satisfy the requirements from industries. That is, the present inventors noticed that the pervaporation method is a method for removing water by bringing the permeation side of a membrane under negative pressure instead of applying pressure to the feed side of the membrane general reverse osmosis method. Then, the inventors completed the present invention that tenders the same effect as that of the conventional apparatus shown in Fig. 1 by using a PV membrane module and vacuum generator in addition to the organic-solvent evaporation bath, and the above-described pump can be omitted.

To pass solvent through the PV membrane module, it is unnecessary to apply pressure for permeation to the feed side of the membrane. Therefore, the pump described above is only used to feed solvent to the PV membrane module. Therefore, the inventors invented a system capable of removing water from solvent in the evaporation bath by immersing the PV membrane module in a liquid phase of an organic solvent in the evaporation bath or exposing it to vapor phase in the evaporation bath, and bringing the permeation side of the PV membrane module under negative pressure to allow the pump described above to be omitted.

That is, the first embodiment of the present invention is an organic-solvent evaporation bath having a PV membrane module for removing water, wherein the module is set to the evaporation bath at a portion where a part or all of the module is directly immersed in a liquid phase of an organic solvent in the evaporation bath.

The second embodiment of the present invention is an organic-solvent evaporation bath having a PV membrane module for removing water, wherein the module is set to the evaporation bath at a portion where the module exists in a vapor phase in the evaporation bath.

The organic-solvent evaporation bath is preferably used as a system for cleaning and drying water-washed semiconductor materials with a vaporized organic solvent.

Furthermore, the third embodiment of the present invention is a method for reclaiming an organic solvent used for drying semiconductor materials after being washed with water, immersing a part or all of a PV membrane module in a liquid phase of an organic solvent containing water present in an organic-solvent evaporation bath, and bringing the membrane permeation side of the module under negative pressure to pass water in the organic solvent through the membrane, so as to remove water from the organic solvent.

In addition, the fourth embodiment of the present invention is a method for reclaiming an organic solvent used for drying semiconductor materials after being washed with water, setting a PV membrane module in a vapor phase containing aqueous vapor and an organic-solvent vapor present in an organic-solvent evaporation bath, and bringing the membrane permeation side of the module under negative pressure to pass aqueous vapor in the vapor phase through the membrane, so as to remove the water from the organic solvent.

[Examples]

The present invention is described in detail by referring to the drawings.

Fig. 1 shows a conventional system made by combining an evaporation bath and an organic-solvent reclaiming apparatus. Figs. 2, 3, and 4 show examples of the systems including the evaporation bath equipped with the organic-solvent reclaiming module according to the present invention. In Figs. 1 through 4, numeral 1 is a solvent feed pipe, 2 is the solvent liquid phase, 20 is the solvent vapor phase, 3 is an evaporation bath, 4 is a heater, 5 is a cooler, 6 is an object to be cleaned, such as a wafer, 7 is a liquid-feed-pump suction pipe, 8 is a liquid feed pump, 9 is a PV membrane module, 10 is a solvent return pipe, 11 is a vacuum-pump suction pipe, 12 is a condenser, 13 is a cooling-water pipe, 14 is a drain pipe, 15 is a vacuum pump, and 16 is an exhaust pipe.

By comparing Fig. 1 with Figs. 2 through 4, it can be easily seen that the system is compact in the present invention because the liquid feed pump 8 and, the liquid-feed-pump suction pipe 7 and the solvent return pipe 10 which are pipes connected with the liquid feed pump 8, which are used for the conventional system (See Fig. 1) are not used since the PV membrane module 9 is set in the evaporation bath 3.

The evaporation bath 3 in Fig. 2 is arranged so that all of the PV membrane module 9 is immersed in the solvent liquid phase 2 when an organic solvent is put in the bath.

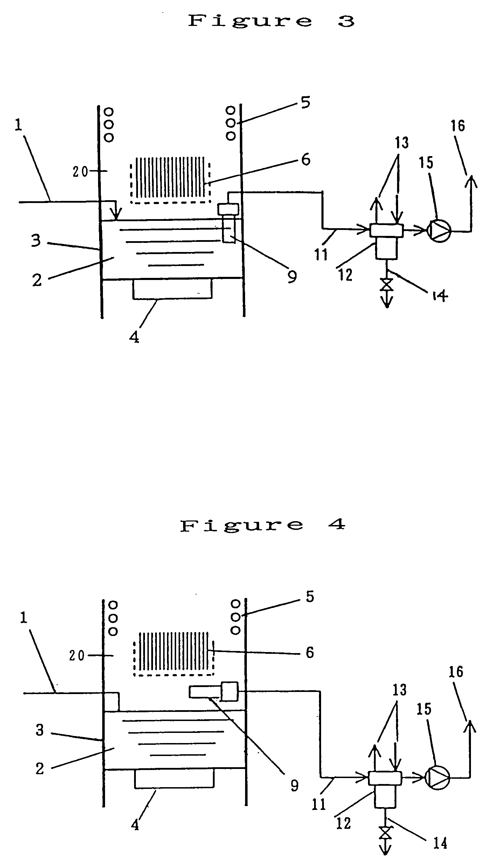

The evaporation bath 3 in Fig. 3 is arranged so that a part, preferably the activee part, of the PV membrane module 9 is immersed in the solvent liquid phase 2 when an organic solvent is put in the bath.

The evaporation bath 3 in Fig. 4 is arranged so that the PV membrane module 9 is set to a position which is to be the solvent vapor phase 20 when an organic solvent is put in the bath.

There is little difference in the water removing performance of the PV membrane module whether it is immersed in the liquid phase of an organic solvent, such as IPA, or it is exposed in the vapor phase of an organic solvent. The position of the PV membrane module in the evaporation bath is not restricted. Therefore, the positions shown in Figs. 2, 3, and 4 are possible.

As for the PV membrane module, a hollow fiber membrane module, a plated and frame module, a tubular module, a pleated module or a spiral module may be used.

Though the organic-solvent evaporation bath must have the PV membrane module, other conditions are not restricted.

When the evaporation bath 3 in Fig. 2 or 3 is used to dry semiconductor materials after washed with water, it is necessary to put organic solvent such as IPA in the evaporation bath 3 and set the object to be cleaned 6 in the position that it is to be the solvent vapor phase 20. In this case, by bringing the membrane permeation side of the PV membrane module 9 under negative pressure by any method, the organic solvent is reclaimed because the water, which is initially attached to the object to be cleaned 6 and then is absorbed in the organic solvent, is removed by passing through the membrane module.

When the evaporation bath 3 in Fig. 4 is used to dry semiconductor materials after being washed with water, it is only necessary to put organic solvent in the bath, set the object to be cleaned 6, and bring the permeation membrane side of the PV membrane module 9 under negative pressure by any method, similar to the above case. Thus, organic solvent is reclaimed because the aqueous vapor, which is removed from the object to be cleaned 6 and is contaminated with the solvent vapor phase 20, is removed by passing through the membrane module.

In any case, suction by a vacuum pump (oil-sealed rotary vacuum type or water-seal type), suction by an ejector, or a combination of these methods can be used as the means for bringing the membrane permeation side of the PV membrane module 9 under negative pressure.

Though the degree of negative pressure is not restricted, 0.1 to 200 mmHg is preferable.

[Effects of the Invention]

The effect according to the system being compact is described below. For conventional combination of an evaporation bath and a solvent reclaiming apparatus (See Fig. 1), the case for housing the PV membrane module 9 and the liquid feed pump 8 requires the dimensions of $55 \times 35 \times 15$ cm excluding the capacitor 12 and vacuum pump 15 which can be set separately from the evaporation bath 3. For the present invention, however, the PV membrane module 9 is stored in the evaporation bath 3 and no liquid feed pump is required. Therefore, a housing case is unnecessary and the space for the size of the evaporation bath 3 is sufficient.

This greatly contributes to the case that one wishes to install a solvent reclaiming apparatus to an existing evaporation bath.

Moreover, the present invention does not have the liquid feed pump 8. This means that there is no risk of ignition of solvent or contamination of foreign matters with the solvent. Therefore, the present invention greatly contributes to safety and quality.

For use of the organic-solvent evaporation bath of the first embodiment of the present invnetion or in the method of the third embodiment of the present invention, the organic solvent in the evaporation bath 3 continuously circulates because it is constantly heated by the heater 4. Therefore, it has been found that there is no difference in the water removing performance compared with the case that the organic solvent is fed to the external PV membrane module by the liquid feed pump 8 (The embodiment according to the prior art, See Fig. 1).

For use of the organic-solvent evaporation bath of the second embodiment of the present invention or in the method of the fourth embodiment of the present invention, the water removing performance is the same as the above and, moreover, the effects are also obtained that substances which leach out from the PV membrane module 9 to the organic solvent are a little and substances contaminating wafers are not greatly accumulated in the organic solvent, because the PV membrane module 9 does not directly contact the organic-solvent liquid.

**Claims**

1. An organic-solvent evaporation bath having a pervaporation membrane module for reclaiming an organic solvent by removing water from the solvent, wherein the module is set to the evaporation bath at a portion where a part or all of the module is directly immersed in a liquid phase of the organic solvent in the evaporation bath.

2. An organic-solvent evaporation bath having a pervaporation membrane module for reclaiming organic solvent by removing water from the solvent, wherein the module is set to the evaporation bath at a portion where the module exists in a vapor phase in the evaporation bath.

3. The organic-solvent evaporation bath according to claims 1 or 2, wherein the organic-solvent evaporation bath is one used for a system for cleaning and drying water-washed semiconductor materials with an organic-solvent vapor.

4. A method for reclaiming an organic solvent used for drying semiconductor materials after being washed with water, comprising the steps of:

    immersing a part or all of a pervaporation membrane module in a liquid phase of an organic solvent containing water present in an organic-solvent evaporation bath; and

    bringing the membrane permeation side of the module under negative pressure to pass water in the organic solvent through the membrane, so as to remove water from the organic solvent.

5. A method for reclaiming an organic solvent used for drying semiconductor materials after being washed with water, comprising the steps of:

    setting a pervaporation membrane module in a vapor phase containing aqueous vapor and an organic-solvent vapor present in an organic-solvent evaporation bath; and

    bringing the membrane permeation side of the module under negative pressure to pass the aqueous vapor in the vapor phase through the membrane, so as to remove the water from the organic solvent.

Figure 1

Figure 2

# Figure 3

# Figure 4

# INTERNATIONAL SEARCH REPORT

International Application No  PCT/JP91/01499

### I. CLASSIFICATION OF SUBJECT MATTER (if several classification symbols apply, indicate all) 6

According to International Patent Classification (IPC) or to both National Classification and IPC

Int. Cl$^5$  B01D61/36, 12/00, H01L21/304

### II. FIELDS SEARCHED

| Minimum Documentation Searched 7 | |
|---|---|
| Classification System | Classification Symbols |
| IPC | B01D61/36, 12/00, B08B3/08, C23G5/04, H01L21/304 |

Documentation Searched other than Minimum Documentation
to the Extent that such Documents are Included in the Fields Searched 8

| | |
|---|---|
| Jitsuyo Shinan Koho | 1926 – 1991 |
| Kokai Jitsuyo Shinan Koho | 1971 – 1991 |

### III. DOCUMENTS CONSIDERED TO BE RELEVANT 9

| Category * | Citation of Document, 11 with indication, where appropriate, of the relevant passages 12 | Relevant to Claim No. 13 |
|---|---|---|
| A | JP, A, 62-133091 (Tokuyama Soda Co., Ltd.), June 16, 1987 (16. 06. 87), & US, A, 4,788,043 | 1-5 |
| A | JP, A, 61-239628 (Tokuyama Soda Co., Ltd.), October 24, 1986 (24. 10. 86), & US, A, 4,788,043 | 1-5 |
| A | JP, A, 01-293104 (Mitsubishi Rayon Engineering Co., Ltd. and another), November 27, 1989 (27. 11. 89), Claim 1, Fig. 1 (Family: none) | 1-5 |
| A | JP, A, 02-82199 (Mitsubishi Heavy Industries, Ltd.), March 22, 1990 (22. 03. 90), Claim, Fig. 4 (Family: none) | 1-5 |
| A | JP, A, 62-161736 (Tokuyama Soda Co., Ltd.), July 17, 1987 (17. 07. 87), (Family: none) | 4-5 |

* Special categories of cited documents: 10

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance: the claimed invention cannot be considered novel or cannot be considered to involve an inventive step

"Y" document of particular relevance: the claimed invention cannot be considered to involve an inventive step when the document is combined with one or more other such documents, such combination being obvious to a person skilled in the art

"&" document member of the same patent family

### IV. CERTIFICATION

| Date of the Actual Completion of the International Search | Date of Mailing of this International Search Report |
|---|---|
| January 21, 1992 (21. 01. 92) | February 12, 1992 (12. 02. 92) |

| International Searching Authority | Signature of Authorized Officer |
|---|---|
| Japanese Patent Office | |

Form PCT/ISA/210 (second sheet) (January 1985)